# FASCICULE DE BREVET EUROPEEN

(11) **EP 1 673 715 B1**
(45) Date de publication et mention de la délivrance du brevet: **26.12.2012**
(21) Numéro de dépôt: 04817215.9
(22) Date de dépôt: 12.10.2004
(51) Int. Cl.: G06K 19/077

(54) **PROCEDE DE FABRICATION D'UNE CARTE A DOUBLE INTERFACE, ET CARTE A MICROCIRCUIT AINSI OBTENUE**
VERFAHREN ZUR HERSTELLUNG EINER KARTE MIT DOPPELSCHNITTSTELLE UND SO ERHALTENE MIKROSCHALTUNGSKARTE
METHOD FOR PRODUCTION OF A CARD WITH A DOUBLE INTERFACE AND MICROCIRCUIT CARD OBTAINED THUS

(30) Priorité: 17.10.2003 FR 0312204
(43) Date de publication de la demande: 28.06.2006
(73) Titulaire: Oberthur Technologies, 92300 Levallois-Perret (FR)
(72) Inventeur: LAUNAY, François, F-14610 Epron (FR); VENAMBRE, Jacques, F-14123 Ifs (FR)
(74) Mandataire: Quantin, Bruno Marie Henri
(86) Numéro de dépôt international: PCT/FR2004/002582
(87) Numéro de publication internationale: WO 2005/038702

(56) Documents cités:
- EP-A- 1 260 938
- FR-A- 2 716 281
- FR-A- 2 769 389

## Description

### Domaine de l'invention et état de la technique

L'invention concerne une carte à microcircuit comportant un microcircuit et, dans son épaisseur, des bornes de connexion à un composant que l'on veut connecter à des contacts internes de ce microcircuit. Elle vise en particulier, mais non exclusivement, des cartes du type à double interface, c'est-à-dire qui fonctionne à la fois grâce à des données transmises par des contacts et grâce à des données transmises sans contact, via une antenne. Une telle carte est souvent dénommée « Dual Interface » ou « Combi ».

On connaît des cartes de ce type qui n'emploient qu'un seul microcircuit, notamment d'après le brevet FR-2716281 (GEMPLUS).

Ce microcircuit fait partie d'un module comportant un film-support portant ce microcircuit sur sa face interne. Ce film-support comporte également, sur sa face externe, des contacts externes connectés au microcircuit et, sur sa face interne, des contacts internes également connectés au microcircuit et coopérant avec des bornes ou terminaux de connexion à l'antenne, situées dans l'épaisseur de la carte. Ce module est fixé dans une cavité d'un corps de carte dans l'épaisseur duquel est réalisée l'antenne, et les bornes de l'antenne sont accessibles dans cette cavité.

Les cartes à double interface peuvent poser de graves problèmes de fiabilité, provenant en pratique de la rupture de la connexion électrique entre les bornes de l'antenne et les contacts internes du module (reliés aux entrées/sorties radiofréquences du microprocesseur de ce microcircuit).

Cette connexion est en général réalisée, soit par soudure à l'aide de pâtes en alliages métalliques (étain-plomb, indium-cadmium-plomb ou indium-étain, le plus souvent), soit par collage à l'aide de colles conductrices, soit encore par fixation du microcircuit à l'aide d'un adhésif anisotrope.

En pratique, la cavité est bordée par un gradin où les bornes sont accessibles en vue de leur connexion au microcircuit. Le gradin sur lequel sont disposées les bornes peut être unique (une connexion par adhésif conducteur anisotrope peut alors à elle seule assurer le maintien mécanique et la connexion électrique), mais ce gradin peut aussi être bordé par un second gradin, auquel cas la fixation du module peut se faire par une colle ou un adhésif entre la périphérie du module et ce second gradin tandis que la liaison électrique entre le microcircuit et les bornes est réalisée par la pâte de soudure ou la colle conductrice précitée. Quant au microcircuit, il est souvent enrobé dans une résine d'encapsulation, pour des raisons de protection.

Or, au cours des flexions mécaniques inévitablement exercées sur la carte au cours de sa vie, les diverses connexions sont soumises à de fortes contraintes mécaniques qui tendent à décoller le microcircuit vis-à-vis du film-support mais aussi et surtout à décoller le module vis-à-vis du corps de carte et donc, a fortiori, à rompre la liaison électrique entre ledit microcircuit et les bornes d'antenne.

La connexion entre le module et l'antenne doit en fait être suffisamment rigide pour à la fois bien maintenir le microcircuit pendant les cycles de flexion et bien conserver la connexion électrique, mais il est par ailleurs souhaitable qu'elle soit également suffisamment flexible pour absorber les fortes contraintes s'exerçant sur elle, sans se rompre.

A cet égard, les liaisons par soudure ou par colle conductrice peuvent paraître trop rigides puisqu'elles ont souvent tendance à se rompre (ruptures cohésives).

En ce qui concerne les adhésifs anisotropes conducteurs, ils ont un comportement variable en fonction de leur flexibilité.

Ainsi un adhésif rigide de fort module d'Young subira une forte contrainte même pour de faibles déformations et aura tendance à rester déformé (au delà de sa limite d'élasticité) ou à se casser.

Par contre un adhésif flexible pourra se déformer aisément en absorbant ainsi les contraintes. Toutefois cette forte déformation n'est pas souhaitable pour le maintien de la connexion électrique (il faut rappeler ici que, dans le cas d'une connexion par adhésif conducteur anisotrope, la liaison électrique est assurée par des billes conductrices noyées dans la masse adhésive). En outre, le corps de carte porteur des bornes d'antenne, souvent réalisé en matière plastique, peut être lui-même déformé de façon permanente ou viscoélastique lors des flexions ou encore sous l'effet de cycles thermiques. Une forte flexibilité de la masse adhésive peut ainsi conduire à un déplacement des billes conductrices, avec pour possible conséquence une rupture irréversible ou intermittente de la connexion électrique.

Il faut ici rappeler une caractéristique essentielle des adhésifs conducteurs anisotropes : la conductivité ne se fait que si un nombre suffisant (en pratique, quelques dizaines/mm²) de billes conductrices sont "écrasées" entre les deux surfaces conductrices mises en connexion par ledit adhésif.

On comprend donc aisément qu'une déformation résiduelle du corps de carte plastique ou du module portant le microcircuit, ainsi qu'un déplacement significatif (étirement) de la masse adhésive peuvent affecter significativement la connexion électrique en déplaçant les billes ou en augmentant la distance entre les deux surfaces de façon à ce que les billes ne soient plus en contact avec l'une ou l'autre de ces surfaces.

A défaut de pouvoir trouver un compromis satisfaisant entre flexibilité et rigidité avec un matériau unique, il est possible d'essayer de jouer sur les propriétés des matériaux utilisés à la périphérie du module et de la cavité, dans le cas précité avec deux gradins, avec un matériau assurant la liaison mécanique sur le support plastique et un autre réalisant la connexion électrique. Mais la combinaison des matériaux en périphérie de la cavité utilisée aujourd'hui (colle ou adhésif isolant, d'une part, et pâte de soudure ou colle conductrice, d'autre part) ne donne cependant pas satisfaction pour les raisons suivantes :
* cette configuration n'empêche pas les déformations résiduelles du corps de carte plastique et/ou du microcircuit,
* l'application de deux matériaux différents à proximité immédiate l'un de l'autre est souvent délicate à réaliser (risque de mélange et de pollutions réciproques),
* l'expérience montre que les contraintes mécaniques exercées sur le matériau conducteur restent trop élevées.

Ces problèmes peuvent se rencontrer non seulement avec une antenne, mais aussi avec d'autres composants, enterrés ou non, reliés à des bornes de connexion situées dans l'épaisseur d'un corps de carte, notamment avec des écrans de visualisation, des capteurs de chaleur, des batteries, des capteurs d'empreintes digitales, etc...

### Problème technique et présentation de l'invention

L'invention a pour objet de pallier les inconvénients précités grâce à une configuration ne conduisant pas à une complication sensible du procédé de fabrication, mais garantissant de faibles contraintes appliquées aux connexions électriques, tout en réduisant les risques de déformations résiduelles du corps de carte auprès de la cavité.

L'invention propose à cet effet un procédé de fabrication d'une carte à microcircuit selon lequel on réalise un corps de carte comportant dans son épaisseur des bornes de connexion à un composant électronique et muni d'une cavité ayant un fond et bordée par un gradin sur lequel sont situés ces bornes de connexion et on réalise un module comportant un film support portant, sur une face externe, des contacts externes et, sur une face interne, des contacts internes et un microcircuit connecté audits contacts internes puis :
- on applique sur la périphérie de la face interne dudit film un adhésif flexible conducteur anisotrope;
- on dépose dans la cavité du corps de carte une résine qui, après polymérisation, a une plus grande rigidité que l'adhésif ;
- on insère dans la cavité le module en sorte que l'adhésif anisotrope se situe en regard de la périphérie du gradin de la cavité ;
- on active thermiquement l'adhésif anisotrope sous pression, et on polymérise la résine.

Ce composant est avantageusement une antenne. En d'autres termes, l'invention propose de combiner-l'utilisation d'un adhésif anisotrope flexible en périphérie de cavité et d'une résine rigide assurant la fixation du microcircuit dans la cavité..

L'utilisation d'une telle configuration permet la déformation élastique de l'adhésif périphérique pendant les flexions mécaniques tout en réduisant fortement la déformation du film-support et du microcircuit dans la cavité et tend à ramener le système dans son état initial après les flexions.

L'utilisation d'une résine de protection d'un microcircuit pour sa fixation dans la cavité d'un corps de carte, en pratique en matière plastique, est en fait déjà connue en soi, notamment d'après des documents de la demanderesse : EP-0 519 564, EP-1 050 844, EP-1 050 845 ou FR-2833801. Un module est fixé dans une cavité au moyen d'une résine d'encapsulation, qui enrobe le microcircuit et ses fils de connexion. En fait, cette résine d'encapsulation du microprocesseur et de ses fils de connexion n'est pas déposée sur le film support du microcircuit mais dans la cavité du support plastique avant insertion du microcircuit. On obtient ainsi un contrôle aisé du volume de la résine d'encapsulation, limité naturellement par la cavité.

Il est même proposé, dans le document EP-0 519 564, de disposer en outre une colle entre la périphérie du module et un gradin bordant à un niveau intermédiaire la cavité. Mais cette colle et cette résine assurent chacune une même fonction de liaison mécanique.

En outre, il mérite d'être souligné que ces documents concernent des cartes plus simples que celles visées par l'invention, dans la mesure où elles ne comportent pas d'antenne, ou de composant muni de bornes de connexion enterrées, de sorte que le seul problème qui y est à résoudre est d'assurer une bonne tenue mécanique du module et du microcircuit qu'il comporte, sans à avoir à se préoccuper en même temps d'une quelconque connexion électrique entre ce module et le corps de carte. Il n'y avait donc aucun souci de préserver de quelconques bornes à la périphérie de la cavité.

Compte tenu des habituelles difficultés à assurer une bonne connexion électrique entre un module et les bornes d'antenne, il est en fait classique, lors de la fabrication de cartes de type « Dual Interface » d'encapsuler le microcircuit avant de se préoccuper de monteur le module dans la cavité d'un corps de carte (on parle alors de microcircuit pré-encapsulé).

Par ailleurs, lorsqu'il a été proposé d'utiliser un adhésif conducteur anisotrope, cela a généralement été fait pour assurer simultanément une liaison mécanique et une connexion électrique, et non pas pour coopérer avec un autre matériau assurant la fonction de liaison mécanique.

L'invention propose pourtant de combiner ces matériaux, en choisissant en outre l'adhésif conducteur anisotrope et la résine l'une en fonction de l'autre, en sorte que l'adhésif soit sensiblement plus flexible que la résine, c'est-à-dire dont le module d'Young est plus faible que celui de cette résine.

Or il est apparu que, les opérations de mise en oeuvre de la résine d'encapsulation, d'une part, et celle de mise en oeuvre d'un adhésif conducteur anisotrope, d'autre part, étaient parfaitement compatibles, et pouvaient donc être simultanées, sans risque de mélange des deux matériaux et sans risque de détérioration des bornes conductrices à la périphérie de la cavité. En outre, les procédures actuelles permettent désormais de réaliser simultanément une connexion électrique fiable entre des contacts de connexion d'un microcircuit et des bornes d'une antenne réalisée au sein du corps de carte, tout en réalisant une fixation du microcircuit dans la cavité.

De manière préférée, l'invention propose de choisir une résine d'encapsulation du microcircuit ayant un coefficient de retrait significatif (quelques %).

Le phénomène de retrait ("shrinkage en anglais ") ou de contraction du volume occupé par la résine a lieu lors de la polymérisation de cette dernière. Ainsi une résine époxy, par exemple, va passer d'un état visqueux à un état solide lors de la formation d'un réseau de molécules tridimensionnel caractéristique de la résine polymérisée.

Ce mécanisme, ainsi que l'évaporation d'éventuels solvants utilisés dans la résine, conduit à une contraction du volume de l'encapsulant qui va ainsi exercer une "force de rappel" entre la surface (généralement le fond) de la cavité du corps de carte et le microcircuit et plus généralement le module dans son ensemble.

Ce phénomène (de l'ordre de quelques pour cent en volume, typiquement entre 1 et 5%) contribue à prévenir les effets de séparation aux interfaces et participe ainsi à la rigidification de l'ensemble corps de carte - microcircuit dans la région de la cavité (et donc des bornes d'antenne), limitant ainsi fortement les déformations résiduelles après flexion.

Cela rend d'autant plus acceptable de choisir un adhésif anisotrope de grande flexibilité (par exemple utilisant une matrice polyester) puisque celle-ci subira plus facilement les contraintes mécaniques sans pour autant conduire à une altération irréversible de la connexion électrique (obtenue rappelons-le par "écrasement" de billes conductrices).

A titre d'exemple, des cycles de flexion mécaniques ont été effectués suivant la Norme internationale ISO 10373 sur des cartes de type « Dual interface » réalisées suivant la présente invention et sur des cartes « Dual interface » réalisées à l'aide de microcircuits pré-encapsulés collés à l'aide d'un adhésif anisotrope semi-rigide largement utilisé dans la profession : les cartes réalisées suivant l'invention sont apparues être toutes parfaitement fonctionnelles après 4000 cycles de flexions alors que certaines des cartes de "référence" ne fonctionnaient déjà plus après 1250 cycles seulement (après 4000 cycles, toutes les cartes référence sont apparues être devenues inopérantes).

Il est également apparu que la structure obtenue résiste également beaucoup mieux aux forces de pression, la résine reliant le microcircuit au fond de la cavité empêchant toute déformation du microcircuit par rapport au corps de carte plastique si une pression lui est appliquée.

Il est à noter que la présente invention peut être utilisée avantageusement avec une structure de corps de carte plastique alternant des couches ayant des propriétés mécaniques et thermiques optimisées de façon à résister aux flexions sans initiation de fissures internes qui pourraient également affecter la résistance de la connexion entre l'antenne (ou le composant considéré) et le microcircuit.

Selon une autre caractéristique avantageuse de l'invention, les bornes d'antennes sont multiples et réparties en plusieurs zones autour de la cavité (de préférence, longitudinalement et transversalement par rapport à l'axe longitudinal du corps de carte), ce qui permet de réduire les exigences de bon positionnement du module par rapport à la cavité lors de la fixation, et de minimiser les risques de déconnexion lors des flexions, qu'elles soient parallèles au petit coté ou au grand coté de la carte.

C'est ainsi que, selon des caractéristiques avantageuses de l'invention, éventuellement combinées :
- le composant électronique est une antenne,
- la résine est choisie en sorte de présenter un coefficient de retrait d'au moins de l'ordre du pourcent lors de sa polymérisation, grâce à quoi, lors de cette opération, le volume occupé par ladite résine se contracte,
- l'on polymérise la résine à une température plus basse que celle à laquelle on active thermiquement l'adhésif,
- l'on active l'adhésif à une température d'activation de l'ordre de 150°C-160°C et l'on polymérise la résine à une température significativement inférieure à cette température d'activation (par exemple aux alentours de 60°C),
- l'on conforme les bornes de connexion en sorte que l'une au moins d'entre elles soit subdivisée en au moins deux plages disposées à distance l'une de l'autre,
- l'on conforme les bornes de connexion en sorte que ces deux plages soient situées en des zones du gradin présentant des orientations différentes vis-à-vis d'une direction de référence du corps de carte,
- l'on conforme chaque borne de connexion en sorte qu'elle soit subdivisée en au moins deux plages qui font face à des plages de l'autre borne de connexion selon des directions différentes,
- l'on conforme chaque borne de connexion en sorte que chacune d'entre elles soit subdivisée en au moins deux plages, dont l'une borde la cavité transversalement au corps de carte, et dont l'autre borde longitudinalement cette cavité,
- les contacts internes du module qui sont en regard des bornes de connexion sont réalisés en une pluralité de plages de contact,
- les plages de contact sont disposées en sorte de border selon des directions différentes la cavité,
- l'on réalise le corps de carte au moyen de couches de matériaux choisis dans le groupe constitué du polychlorure de vinyle, de l'acrylonitrile butadiène styrène, du polyéthylène téréphtalate ou polycarbonate,
- l'on réalise le corps de carte sous la forme d'une alternance de telles couches.

L'invention propose également une carte adaptée à être obtenue selon ce procédé, c'est-à-dire une carte à microcircuit comportant un corps de carte comportant dans son épaisseur des bornes de connexion à un composant et muni d'une cavité ayant un fond et bordée par un gradin sur lequel sont situés ces bornes de connexion et un module comportant un film support portant, sur une face externe, des contacts externes et, sur une face interne, des contacts internes et un microcircuit connecté audits contacts internes dans lequel :
- les contacts internes sont connectés aux bornes de connexion par un adhésif conducteur anisotrope;
- le microcircuit est encapsulé dans une résine s'étendant jusqu'à une portion de fond de la cavité, cette résine étant de plus grande rigidité que l'adhésif.

Les caractéristiques avantageuses mentionnées ci-dessus à propos du procédé s'appliquent ici. En particulier le composant est avantageusement une antenne.

### Description de l'invention

Des objets, caractéristiques et avantages de l'invention ressortent de la description qui suit, donnée à titre illustratif non limitatif, en regard des dessins annexés sur lesquels :
- la figure 1 est une vue de dessus d'une antenne et de ses bornes de connexion, dans un mode de réalisation préféré,
- la figure 2 est une vue de dessous du module, montrant des contacts internes,
- la figure 3 est une vue de dessus montrant à la fois l'antenne et la superposition des contacts internes du module et des bornes de connexion,
- la figure 4 est une vue partielle en coupe d'une carte à puce intégrant l'antenne et le module, et
- la figure 5 est une vue en coupe montrant un corps de carte adapté à coopérer avec le module de la figure 2, selon une variante de réalisation.

Les figures annexées représentent diverses étapes dans la fabrication d'une carte à puce selon l'invention.

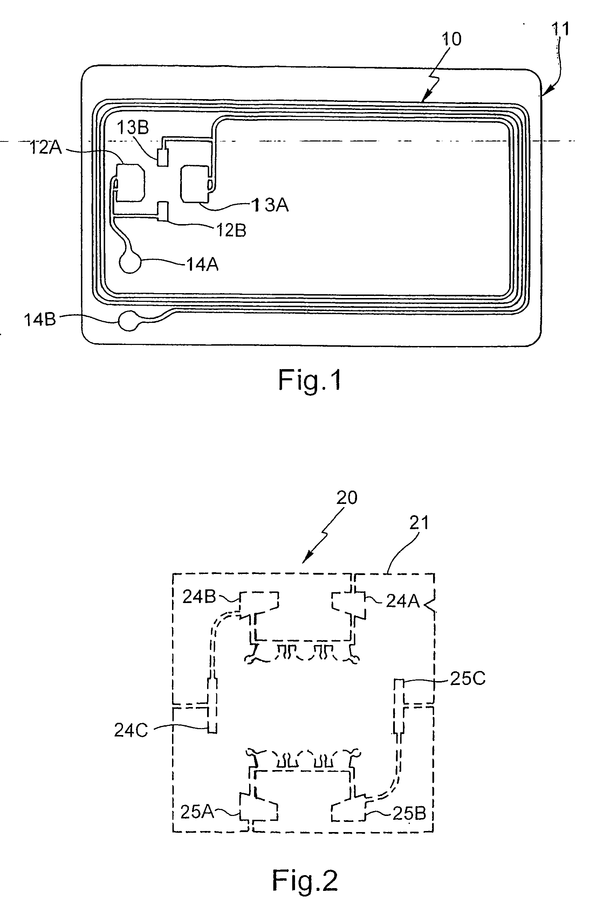

La figure 1 montre un composant ici constitué d'une antenne 10 réalisée sur un film 11 couramment appelé inlay. Cet inlay a ici sensiblement le même format que le corps de carte dans lequel cette antenne est destinée à faire partie, et les spires s'étendent sensiblement auprès de chaque côté de cet inlay. En variante non représentée, l'antenne est sensiblement plus petite.

Cette antenne est formée de spires conductrices, typiquement en cuivre photogravé.

De manière avantageuse, cette antenne comporte deux bornes de connexion décomposées en plusieurs zones, ici au nombre de deux pour chaque borne : plus précisément, l'antenne comporte deux plages de connexion 12A et 13A, disposées en regard selon une direction longitudinale de l'inlay et deux autres plages de connexion 12B et 13B qui se font également, mais selon une direction différente de celle des plots précités, ici selon une direction transversale de l'inlay.

Ainsi, dans l'exemple considéré, chaque extrémité de l'antenne est subdivisée en au moins deux plages qui font face à des plages de l'autre extrémité selon au moins deux directions différentes de l'inlay.

En pratique, on part d'une feuille, par exemple en PVC avec une épaisseur de l'ordre de 200 microns, sur laquelle on trace un réseau d'antennes généralement identiques par gravure chimique d'une couche de cuivre électro-déposée à une épaisseur de l'ordre de 35 microns.

Ainsi qu'on le sait la géométrie de l'antenne est réalisée de façon à répondre à des spécifications électriques bien précises (notamment, fréquence d'accord pour une capacité donnée du circuit imprimé avec lequel chaque antenne est destinée à coopérer, résistance choisie en fonction du facteur de qualité, etc...). Les paramètres géométriques significatifs sont la largeur de l'antenne, la largeur des spires et leur intervalle, l'épaisseur de cuivre, etc...

La subdivision en plusieurs plages de connexion des extrémités de l'antenne conduit à augmenter la surface de connexion (donc à diminuer les résistances de contact) et à fiabiliser la connexion finale. En effet, les plages latérales 12A et 13A (disposées longitudinalement à l'inlay) sont plus sensibles aux contraintes de type flexion selon le grand côté alors que les plages verticales 12B et 13B (disposées transversalement à l'inlay) sont plus sensibles aux contraintes de type flexion selon le petit côté de l'inlay). Cette subdivision optimise donc la probabilité de conserver un contact avec l'antenne, quelque soit le type de flexion subi.

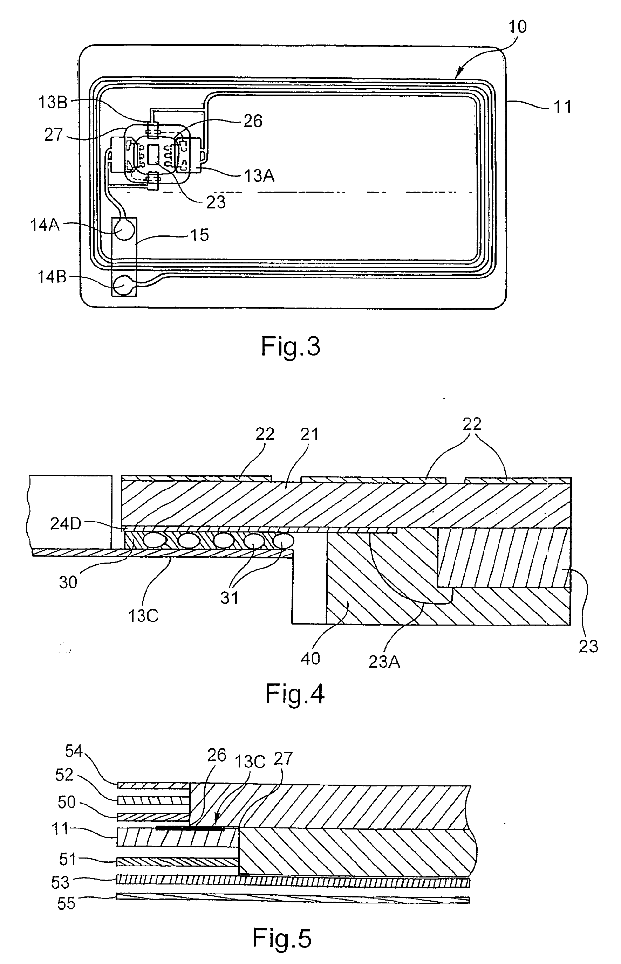

On peut noter que l'antenne est ici incomplète, puisqu'on observe deux bornes 14A et 14B disposées, à la figure 1 au dessus et au dessous des fibres inférieures. La liaison entre ces bornes peut être réalisée par un pont (représenté à la figure 3 sous la référence 15) réalisé sur la face de l'inlay qui est à l'opposé des spires de l'antenne.

De manière avantageuse, une opération de pressage à chaud permet d'enterrer les spires et le pont dans l'épaisseur du matériau constitutif de l'inlay, ce qui permet de minimiser les reliefs dus à ces spires et à ce pont.

De manière connue en soi, une étape de lamination est ensuite réalisée en sorte que la feuille sur laquelle est réalisée le réseau d'antennes se trouve prise en sandwich entre d'autres feuilles à l'intérieur d'un réseau de corps de carte. Et c'est ensuite que, de manière classique, on découpe chaque corps de carte.

L'épaisseur des feuilles laminées est choisie en sorte de situer les spires à la profondeur voulue, par exemple à une profondeur de 260 microns de la surface supérieure du corps de carte. Cette distance est définie en fonction de la géométrie du module avec lequel l'antenne est destinée à coopérer.

Après découpe au format d'une carte à puce, les feuilles laminées forment conjointement un corps de carte.

En parallèle est préparé un module 20 pour chaque antenne, chaque module comportant, sur un film-support 21, des contacts externes 22, un microcircuit 23, et des contacts internes reliés par des fils 23A au microcircuit (voir ci-dessus).

Cette préparation comporte par exemple le sciage des circuits imprimés puis leur collage sur le film-support, la fixation par soudure de fils de connexion. La réalisation d'un module pour carte de type « Dual Interface » requiert de préférence l'utilisation de modules ayant des couches de conducteurs sur chacune de ses faces, avec des trous, métallisés ou non, pour la-traversée de ce film-support ; il y a par exemple un niveau supérieur de conducteurs en cuivre de 35 microns comme sur des modules classiques à contacts externes (contacts IS Vcc, Vss,...) et un niveau inférieur permettant la liaison électrique de l'antenne avec les entrées du microcircuit. L'antenne n'est en principe pas accessible de l'extérieur.

La géométrie des contacts externes 22 ne faisant pas partie de l'invention, elle ne sera pas détaillée ici.

La figure 2 représente un exemple de réalisation de géométrie des contacts internes d'un module (donc au niveau inférieur précité). Par analogie avec ce qui a été dit à propos des formes de connexion de l'antenne, chaque contact interne du module est subdivisé en au moins deux plages faisant face aux plages de l'autre selon au moins deux directions.

Plus précisément, le module 20 comporte ici un premier contact interne subdivisé en deux plages 24A-24B raccordées par une piste à une autre plage 24C, et un second contact interne subdivisé en deux plages 25A-25B raccordées par une piste à une autre plage 25C. Les plages 24A-24B et les plages 25A-25B se font face selon une direction destinée à être longitudinale dans le corps de carte, tandis que les plages 24C et 25C se font face selon une direction ici orthogonale à la première. Ces plages de contact sont ici soit des trapèzes, soit des rectangles et sont connectées à des zones circulaires pouvant permettre une connexion à des fils. D'autres formes sont bien entendu possibles pour ces plages de contact.

Les figures 3 et 4 représentent la combinaison d'un corps de carte et d'un module. Pour des raisons de lisibilité de la figure 3, divers éléments apparaissent en transparence au travers des éléments qui les recouvrent.

Chaque corps de carte comporte une cavité pour recevoir un module.

Cette cavité traverse le plan de l'antenne, les bornes de connexion de l'antenne étant matérialisées sur un gradin bordant cette cavité. Cette cavité peut être pré-existante, mais elle est de préférence réalisée en fin d'assemblage du corps de carte. A cet effet, on détecte par tout moyen connu approprié l'emplacement de l'antenne et on enlève de la matière (par exemple le PVC) jusqu'à mettre le cuivre des spires à nu.

Sur la figure 3 apparaissent, en transparence, les spires de l'antenne, le pont 15 reliant les bornes 14A et 14B sous l'inlay, les contours de la cavité (le contour externe 26 et le contour interne 27), le microcircuit 23 et les plages de connexion du module. On voit que les plages 24A à 24C, d'une part, et les plages 25A à 25C, d'autre part, sont collectivement en contact avec les bornes de connexion de l'antenne.

La figure 4 représente en coupe un module fixé dans un corps de carte, selon la configuration de la figure 3.

On observe que, sur le gradin délimité par les contours 26 et 27 de la figure 3, un adhésif 30 est interposée entre les bornes 12B et 13B et les plages 24C et 25C, tandis qu'un bloc de résine 40 encapsulant le microcircuit 23 s'étend jusqu'au fond de la cavité, sous le plan de l'antenne.

Cet adhésif 30 est un adhésif conducteur anisotrope, et comporte des billes conductrices schématisées sous la référence 31 (elles sont bien sûr de bien plus petite taille qu'il apparaît à l'échelle du dessin).

Cet adhésif et la résine sont choisis de telle sorte que l'adhésif 30 a une plus grande flexibilité que la résine 40.

De manière avantageuse, cette résine 40 est adaptée à subir un phénomène de retrait, par exemple en raison de sa polymérisation, ou de l'évaporation de solvants.

Les opérations d'assemblage de ce module dans ce corps de carte peuvent être conduites comme indiqué comme suit.

Lorsque le module est prêt, on revêt sa périphérie de l'adhésif 30 qui est de préférence du type « Hot Melt » avec des billes de verre métallisées à l'argent, de diamètre de l'ordre de 20 à 40 microns, noyées dans une matrice réactivable à des températures de 110 °C à 150 °C. Pour obtenir une flexibilité suffisante, cette matrice est par exemple un polyester.

Par ailleurs, on dépose la résine 40 dans la cavité du corps de carte, avant de mettre le module en place, en sorte d'encapsuler le microcircuit dans cette résine, et de mettre l'adhésif 30 en contact avec les bornes de l'antenne.

Cette résine 40 est avantageusement une résine epoxy de grande pureté ionique ayant un coefficient de retrait significatif.

Après mise en place du module, on active l'adhésif à une température voisine de 160 °C pendant un temps très bref, de l'ordre de 500 ms à 2 s, sous une pression appropriée pour assurer une bonne adhésion de cet adhésif 30 aux plages qu'il sert à connecter électriquement. On polymérise ensuite la résine à une température sensiblement plus faible (pour ne pas affaiblir l'adhésif), typiquement vers 45°C-60°C.

On appréciera que, malgré le fait que l'activation de l'adhésif se fasse à une température sensiblement supérieure à la température de polymérisation, le traitement quasi-simultané de ces divers matériaux est apparu ne pas poser de problèmes particuliers de mise en oeuvre, compte tenu des temps de traitement nécessaires à l'activation de l'adhésif.

Le fait d'avoir choisi, dans l'exemple considéré, une résine présentant un fort coefficient de retrait, garantit qu'il y a en permanence un effort tendant à rapprocher le module du fond, ce qui contribué à réduire les risques de déconnexion électrique entre les contacts internes du module et les bornes de l'antenne lors des efforts de flexion que l'ensemble corps-de-carte/module, c'est-à-dire la carte à puce obtenue, peut être amené à subir.

La figure 5 représente un exemple de réalisation de l'empilement de feuilles conduisant à l'obtention d'un corps de carte.

La lamination consiste à déposer à chaud et sous pression des feuilles de polymères (PVC, PET ou autres) de part et d'autre de l'inlay.

Dans l'exemple représenté, l'inlay 11, dont l'épaisseur est de 200 microns, est pris en sandwich entre deux couches 50 et 51 d'épaisseur égale à environ 100 microns et qui ont un rôle de compensation ; cet empilement 50+11+51 est à son tour pris en sandwich entre deux couches d'impression 52 et 53 d'épaisseur typiquement égale à 140 microns. Enfin des couches de couverture 54 et 55 forment les surfaces extérieures du corps de carte.

C'est ainsi que, de manière avantageuse, le corps de carte est formé d'un empilement de couches de matériaux choisis dans le groupe constitué du polychlorure de vinyle, de l'acrylonitrile butadiène styrène, du polyéthylène téréphtalate ou polycarbonate ; il s'agit de préférence d'une alternance de telles couches.

Pour des raisons de lisibilité de la figure, ces couches sont écartées les unes des autres, mais il faut bien comprendre qu'elles sont en pratique jointives.

On peut en outre noter que le gradin est bien formé à la surface supérieure de l'inlay, et que la cavité descend, sous le plan de cette surface, au travers de l'inlay et de la couche de compensation, les couches inférieures d'impression et de couverture restant intactes.

L'organigramme du procédé peut ainsi se définir ainsi :
- sciage des circuits intégrés,
- collage au sein du module,
- soudage des fils de connexion,
- dépôt de l'adhésif conducteur anisotrope,
- usinage de la cavité,
- dépose de la résine,
- encartage (c'est-à-dire fixation du module dans le corps de carte),
- test de pré personnalisation,
- personnalisation graphique.

La carte est ainsi physiquement terminée.

## Revendications

1. Procédé de fabrication d'une carte a microcircuit selon lequel on réalise un corps de carte comportant dans son épaisseur des bornes de connexion (12A, 13A, 12B, 13B) à un composant électronique et muni d'une cavité ayant un fond et bordée par un gradin sur lequel sont situés ces bornes de connexion et on réalise un module (20) comportant un film support (21) portant, sur une face externe, des contacts externes (22) et, sur une face interne, des contacts internes (24A, 24B, 24C, 25A,25B, 25C) et un microcircuit (23) connecté audits contacts internes, ledit procédé **caractérisé par** les étapes suivantes :
- on applique sur la périphérie de la face interne dudit film un adhésif (30) flexible conducteur anisotrope;
- on dépose dans la cavité du corps de carte une résine (40) qui, après polymérisation, a une plus grande rigidité que l'adhésif ;
- on insère dans la cavité le module en sorte que l'adhésif anisotrope se situe en regard de la périphérie du gradin de la cavité ;
- on active thermiquement l'adhésif anisotrope sous pression, et on polymérise la résine.

2. Procédé selon la revendication 1, **caractérisé en ce que** ce composant est une antenne.

3. Procédé selon la revendication 1 ou la revendication 2, **caractérisé en ce que** la résine est choisie en sorte de présenter un coefficient de retrait d'au moins de l'ordre du pourcent lors de sa polymérisation, grâce à quoi, lors de cette opération, le volume occupé par ladite résine se contracte.

4. Procédé selon l'une quelconque des revendications 1 à 3, **caractérisé en ce que** l'on polymérise la résine à une température plus basse que celle à laquelle on active thermiquement l'adhésif.

5. Procédé selon la revendication 4, **caractérisé en ce que** l'on active l'adhésif à une température d'activation de l'ordre de 150°C-160°C et l'on polymérise la résine à une température significativement inférieure à cette température d'activation (par exemple aux alentours de 60°C).

6. Procédé selon l'une quelconque des revendications 1 à 5, **caractérisé en ce que** l'on conforme les bornes de connexion en sorte que l'une au moins d'entre elles soit subdivisée en au moins deux plages disposées à distance l'une de l'autre.

7. Procédé selon la revendication 6, **caractérisé en ce que** l'on conforme les bornes de connexion en sorte que ces deux plages soient situées en des zones du gradin présentant des orientations différentes vis-à-vis d'une direction de référence du corps de carte.

8. Procédé selon la revendication 6 ou la revendication 7, **caractérisé en ce que** l'on conforme chaque borne de connexion en sorte qu'elle soit subdivisée en au moins deux plages qui font face à des plages de l'autre borne de connexion selon des directions différentes.

9. Procédé selon l'une quelconque des revendications 6 à 8, **caractérisé en ce que** l'on conforme chaque borne de connexion en sorte que chacune d'entre elles soit subdivisée en au moins deux plages, dont l'une borde la cavité transversalement au corps de carte, et dont l'autre borde longitudinalement cette cavité.

10. Procédé selon l'une quelconque des revendications 1 à 9, **caractérisé en ce que** les contacts internes du module qui sont en regard des bornes de connexion sont réalisés en une pluralité de plages de contact plages de contact.

11. Procédé selon la revendication 10, **caractérisé en ce que** les plages de contact sont disposées en sorte de border selon des directions différentes la cavité.

12. Procédé selon l'une quelconque des revendications 1 à 11, **caractérisé en ce que** l'on réalise le corps de carte au moyen de couches de matériaux choisis dans le groupe constitué du polychlorure de vinyle, de l'acrylonitrile butadiène styrène, du polyéthylène téréphtalate ou polycarbonate.

13. Procédé selon la revendication 12, **caractérisé en ce que** l'on réalise le corps de carte sous la forme d'une alternance de telles couches.

14. Carte à microcircuit comportant un corps de carte comportant dans son épaisseur des bornes de connexion (12A, 13A, 12B, 13B) à un composant (10) et muni d'une cavité ayant un fond et bordée par un gradin sur lequel sont situés ces bornes de connexion et un module (20) comportant un film support (21) portant, sur une face externe, des contacts externes (22) et, sur une face interne, des contacts internes (24A, 24B, 24C, 25A, 25B, 25C) et un microcircuit connecté audits contacts internes, ladite carte **caractérisée en ce que**:
- les contacts internes sont connectés aux bornes de connexion par un adhésif (30) conducteur anisotrope;
- le microcircuit (23) est encapsulé dans une résine (40) s'étendant jusqu'à une portion de fond de la cavité, cette résine étant de plus grande rigidité que l'adhésif.

15. Carte selon la revendication 14 **caractérisée en ce que** le composant est une antenne.

16. Carte selon la revendication 14 ou la revendication 15, **caractérisée en ce que** la résine est choisie en sorte de présenter un coefficient de retrait d'au moins de l'ordre du pourcent lors de sa polymérisation, grâce à quoi, après cette opération, le volume occupé par ladite résine est sous tension.

17. Carte selon l'une quelconque des revendications 14 à 16, **caractérisée en ce que** la résine a une température de polymérisation plus basse que la température d'activation de l'adhésif.

18. Carte selon la revendication 17, **caractérisée en ce que** l'adhésif a une température d'activation de l'ordre de 150°C-160°C tandis que la résine a une température de polymérisation significativement inférieure à cette température d'activation (par exemple aux alentours de 60°C).

19. Carte selon l'une quelconque des revendications 14 à 18, **caractérisée en ce que** les bornes de connexion sont conformées en sorte que l'une au moins d'entre elles soit subdivisée en au moins deux plages disposées à distance l'une de l'autre.

20. Carte selon la revendication 19, **caractérisée en ce que** les bornes de connexion sont conformées en sorte que ces deux plages soient situées en des zones du gradin présentant des orientations différentes vis-à-vis d'une direction de référence du corps de carte.

21. Carte selon la revendication 19 ou la revendication 20, **caractérisée en ce que** chaque borne de connexion est conformée en sorte qu'elle soit subdivisée en au moins deux plages qui font face à des plages de l'autre borne de connexion selon des directions différentes.

22. Carte selon l'une quelconque des revendications 19 à 21, caractérisée en ce chaque borne de connexion est conformée en sorte que chacune d'entre elles soit subdivisée en au moins deux plages, dont l'une borde la cavité transversalement au corps de carte, et dont l'autre borde longitudinalement cette cavité.

23. Carte selon l'une quelconque des revendications 14 à 22, **caractérisée en ce que** les contacts internes du module qui sont en regard des bornes de connexion sont réalisés en une pluralité de plages de contact plages de contact.

24. Carte selon la revendication 23, **caractérisée en ce que** les plages de contact sont disposées en sorte de border selon des directions différentes la cavité.

25. Carte selon l'une quelconque des revendications 14 à 24, **caractérisée en ce que** le corps de carte est réalisé au moyen de couches de matériaux choisis dans le groupe constitué du polychlorure de vinyle, de l'acrylonitrile butadiène styrène, du polyéthylène téréphtalate ou polycarbonate.

26. Carte selon la revendication 25, **caractérisée en ce que** le corps de carte est réalisé sous la forme d'une alternance de telles couches.

## Claims

1. A process for the fabrication of a microcircuit card wherein a card body is produced comprising in its thickness terminals (12A, 13A, 12B, 13B) for connection to an electronic component (10) and provided with a cavity having a bottom and edged with a step on which said connecting terminals are disposed and a module (20) is produced comprising a support film (21) carrying external contacts (22) on an external face and internal contacts (24A, 24B, 24C, 25A, 25B, 25C) on an internal face and a microcircuit (23) connected to said internal contacts, said process being caracterised in that:
- an anisotropic conducting flexible adhesive (30) is applied to the periphery of the internal face of said film;
- a resin (40) which after polymerisation is of greater rigidity than the adhesive is deposited in the cavity of the card body;
- the module is inserted into the cavity in such a way that the anisotropic adhesive is disposed facing the periphery of the step of the cavity; and
- the anisotropic adhesive is thermally activated under pressure and the resin is polymerised.

2. A process according to claim 1 **characterised in that** the component is an antenna.

3. A process according to claim 1 or claim 2 **characterised in that** the resin is so selected as to have a shrinkage coefficient of at least of the order of a percent upon polymerisation thereof, by virtue of which in said operation the volume occupied by said resin contracts.

4. A process according to any one of claims 1 to 3 **characterised in that** the resin is polymerised at a lower temperature than that at which the adhesive is thermally activated.

5. A process according to claim 4 **characterised in that** the adhesive is activated at an activation temperature of the order of 150°C - 160°C and the resin is polymerised at a temperature significantly lower than said activation temperature (for example in the vicinity of 60°C).

6. A process according to any one of claims 1 to 5 **characterised in that** the connecting terminals are so shaped that one at least thereof is subdivided into at least two areas disposed at a spacing from each other.

7. A process according to claim 6 **characterised in that** the connecting terminals are so shaped that said two areas are disposed in zones of the step involving different orientations with respect to a reference direction of the card body.

8. A process according to claim 6 or claim 7 **characterised in that** each connecting terminal is so shaped that it is subdivided into at least two areas which face areas of the other connecting terminal in different directions.

9. A process according to any one of claims 6 to 8 **characterised in that** each connecting terminal is so shaped that each of them is subdivided into at least two areas of which one borders the cavity transversely with respect to the card body and the other longitudinally borders said cavity.

10. A process according to any one of claims 1 to 9 **characterised in that** the internal contacts of the module which are in facing relationship with the connecting terminals are made in the form of a plurality of contact areas.

11. A process according to claim 10 **characterised in that** the contact areas are so disposed as to border the cavity in different directions.

12. A process according to any one of claims 1 to 11 **characterised in that** the card body is produced by means of layers of materials selected from the group formed by polyvinyl chloride, acrylonitrile butadiene styrene, polyethylene terephthalate or polycarbonate.

13. A process according to claim 12 **characterised in that** the card body is produced in the form of an alternation of such layers.

14. A microcircuit card comprising a card body comprising in its thickness terminals (12A, 13A, 12B, 13B) for connection to a component (10) and provided with a cavity having a bottom and edged with a step on which are disposed said connecting terminals and a module (20) comprising a support film (21) carrying external contacts (22) on an external face and internal contacts (24A, 24B, 24C, 25A, 25B, 25C) on an internal face and a microcircuit connected to said internal contacts, said card being **characterized in that** :
- the internal contacts are connected to the connecting terminals by an anisotropic conducting adhesive (30) ; and
- the microcircuit (23) is encapsulated in a resin (40) extending to a bottom portion of the cavity, said resin being of greater rigidity than the adhesive.

15. A card according to claim 14 **characterised in that** the component is an antenna.

16. A card according to claim 14 or claim 15 **characterised in that** the resin is so selected as to have a shrinkage coefficient of at least of the order of a percent upon polymerisation thereof, by virtue of which after said operation the volume occupied by said resin is under tension.

17. A card according to any one of claims 14 to 16 **characterised in that** the resin has a lower polymerisation temperature than the activation temperature of the adhesive.

18. A card according to claim 17 **characterised in that** the adhesive has an activation temperature of the order of 150°C - 160°C while the resin has a polymerisation temperature significantly lower than said activation temperature (for example in the vicinity of 60°C).

19. A card according to any one of claims 14 to 18 **characterised in that** the connecting terminals are so shaped that one at least thereof is subdivided into at least two areas disposed at a spacing from each other.

20. A card according to claim 19 **characterised in that** the connecting terminals are so shaped that said two areas are disposed in zones of the step involving different orientations with respect to a reference direction of the card body.

21. A card according to claim 19 or claim 20 **characterised in that** each connecting terminal is so shaped that it is subdivided into at least two areas which face areas of the other connecting terminal in different directions.

22. A card according to any one of claims 19 to 21 **characterised in that** each connecting terminal is so shaped that each of them is subdivided into at least two areas of which one borders the cavity transversely with respect to the card body and the other longitudinally borders said cavity.

23. A card according to any one of claims 14 to 22 **characterised in that** the internal contacts of the module which are in facing relationship with the connecting terminals are made in the form of a plurality of contact areas.

24. A card according to claim 23 **characterised in that** the contact areas are so disposed as to border the cavity in different directions.

25. A card according to any one of claims 14 to 24 **characterised in that** the card body is produced by means of layers of materials selected from the group formed by polyvinyl chloride, acrylonitrile butadiene styrene, polyethylene terephthalate or polycarbonate.

26. A card according to claim 25 **characterised in that** the card body is produced in the form of an alternation of such layers.

## Patentansprüche

1. Verfahren zur Herstellung einer Mikroschaltungskarte gemäß welchem ein Körper der Karte realisiert wird, umfassend in seiner Dicke Verbindungsklemmen bzw. - anschlüsse (12A, 13A, 12B, 13B) mit einer elektronischen Komponente (10) und mit einem Hohlraum ausgestattet, welcher einen Boden und einen Rand durch einen Absatz aufweist, auf welchem diese Verbindungsklemmen angeordnet sind, und ein Modul (20) realisiert wird, umfassend einen Supportfilm (21), der auf einer Außenfläche äußere Kontakte (22) und auf einer Innenfläche innere Kontakte (24A, 24B, 24C, 25A, 25B, 25C) und eine Mikroschaltung (23) trägt, die mit den inneren Kontakten verbunden werden, worauf bzw. **dadurch gekennzeichnet**, daβ :
- man auf dem Umfang der Innenfläche des Films einen flexiblen anisotropen Kontaktkleber (30) aufbringt;
- man in den Hohlraum des Körpers der Karte ein Harz (40) mit größerer Steifigkeit als der Kleber abscheidet;
- man in den Hohlraum das Modul derart einsetzt, daβ der anisotrope Kleber in bezug auf den Umfang des Absatzes bzw. der Abstufung des Hohlraums angeordnet wird;
- man den anisotropen Kleber thermisch unter Druck aktiviert und das Harz polymerisiert.

2. Verfahren nach Anspruch 1, **dadurch gekennzeichnet**, daβ diese Komponente eine Antenne ist.

3. Verfahren nach Anspruch 1 oder Anspruch 2, **dadurch gekennzeichnet**, daβ das Harz derart gewählt wird, um einen Rückhaltekoeffizienten wenigstens in der Größenordnung von Prozent während seiner Polymerisation aufzuweisen, aufgrund dessen sich das durch das Harz eingenommene Volumen während dieser Tätigkeit kontrahiert bzw. zusammenzieht.

4. Verfahren nach einem der Ansprüche 1 bis 3, **dadurch gekennzeichnet**, daβ das Harz bei einer tieferen Temperatur polymerisiert als jene, mit welcher der Kleber thermisch aktiviert wird.

5. Verfahren nach Anspruch 4, **dadurch gekennzeichnet**, daβ der Kleber bei einer Aktivierungstemperatur in der Größenordnung von 150 °C-160 °C aktiviert wird und daβ das Harz bei einer signifikant tieferen Temperatur als die Aktivierungstemperatur polymerisiert wird (beispielsweise bei ungefähr 60 °C).

6. Verfahren nach einem der Ansprüche 1 bis 5, **dadurch gekennzeichnet**, daβ die Verbindungsanschlüsse derart geformt werden, daβ mindestens unter diesen in wenigstens zwei Bereiche unterteilt wird, die in Abstand voneinander angeordnet werden.

7. Verfahren nach Anspruch 6, **dadurch gekennzeichnet**, daβ die Verbindungsklemmen derart ausgeführt werden, daβ die zwei Bereiche in den Zonen der Abstufung angeordnet werden, welche unterschiedliche Ausrichtungen gegenüber einer Bezugsrichtung des Körpers der Karte aufweisen.

8. Verfahren nach Anspruch 6 oder Anspruch 7, **dadurch gekennzeichnet**, daβ jede der Verbindungsklemmen derart ausgeführt wird, daβ sie in wenigstens zwei Bereiche unterteilt ist, welche den Bereichen der anderen Verbindungsklemme entlang unterschiediicher Richtungen gegenüberliegen.

9. Verfahren nach einem der Ansprüche 6 bis 8, **dadurch gekennzeichnet**, daβ jede Verbindungsklemme derart ausgeführt wird, daβ jede unter ihnen in wenigstens zwei Bereiche unterteilt wird, von weichem einer quer an den Hohlraum des Körpers der Karte angrenzt und der andere in Längsrichtung an diesen Hohlraum angrenzt.

10. Verfahren nach einem der Ansprüche 1 bis 9, **dadurch gekennzeichnet**, daβ die inneren Kontakte des Moduls, welche den Verbindungsklemmen gegenüberliegen, aus einer Vielzahl von Kontaktbereichen bzw. -stellen realisiert werden.

11. Verfahren nach Anspruch 10, **dadurch gekennzeichnet**, daβ die Kontaktbereiche 5 derart angeordnet sind, um den Hohlraums entlang unterschiedlicher Richtungen anzugrenzen.

12. Verfahren nach einem der Ansprüche 1 bis 11, **dadurch gekennzeichnet**, daβ der Kartenkörper aus Materialschichten realisiert wird, die aus der Gruppe, bestehend aus Polyvinylchlorid, Acrylnitrilbutadienstyrol, Polyethylenterephthalat oder Polycarbonat gewählt werden.

13. Verfahren nach Anspruch 12, **dadurch gekennzeichnet**, daβ der Kartenkörper alternierend bzw. abwechseind aus derartigen Schichten gebildet wird.

14. Mikroschaltungskarte, einen Kartenkörper umfassend, der in seiner Dicke Verbindungsklemmen bzw. - anschlüsse (12A, 13A, 12B, 13B) umfasst, mit einer Komponente (10) und mit einem Hohlraum ausgestattet, welcher einen Boden und einen Rand durch eine Abstufung aufweist, auf welcher diese Verbindungsklemmen angeordnet sind und ein Modul (20), einen Supportfilm (21) umfassend, der auf seiner Außenfläche externe Kontakte (22) trägt und auf seiner Innenfläche interne Kontakte (24A, 24B, 24C, 25A, 25B, 25C) trägt, und eine Mikroschaltung, die mit den inneren Kontakten verbunden ist, **dadurch gekennzeichnet** daβ:
- die Innenkontakte mit den Verbindungsklemmen durch einen leitfähigen anisotropen Kleber (30) verbunden sind;
- die Mikroschaltung (23) in einem Harz (40) verkapselt ist, welches sich bis zu einem Abschnitt des Bodens des Hohlraums erstreckt, wobei dieses Harz eine größere steifigkeit als der Kleber aufweist.

15. Karte nach Anspruch 14, **dadurch gekennzeichnet**, daβ die Komponente eine Antenne ist.

16. Karte nach Anspruch 14 oder Anspruch 15, **dadurch gekennzeichnet**, daβ das Harz derart gewählt ist, daβ es einen Schrumpfungskoeffizienten von wenigstens der Größenordnung von Prozent während seiner Polymerisation aufweist, aufgrund dessen nach dieser Tätigkeit das durch das Harz eingenommene Volumen unter Spannung steht.

17. Karte nach einem der Ansprüche 14 bis 16, **dadurch gekennzeichnet**, daβ das Harz eine Polymerisationstemperatur tiefer als die Aktivierungstemperatur des Klebers aufweist.

18. Karte nach Anspruch 17, **dadurch gekennzeichnet**, daβ der Kleber eine Aktivierungstemperatur in der Größenordnung von 150°C-160°C aufweist, während das Harz eine Polymerisationstemperatur signifikant unter der Aktivierungstemperatur aufweist (beispielsweise in der Gröβenordnung von 60 °C).

19. Karte nach einem der Ansprüche 14 bis 18, **dadurch gekennzeichnet**, daβ die Verbindungsklemmen derart gebildet sind, daβ wenigstens eine von diesen in wenigstens zwei Bereiche unterteilt ist, welche in Abstand voneinander angeordnet sind.

20. Karte nach Anspruch 19, **dadurch gekennzeichnet**, daβ die Verbindungsklemmen derart ausgebildet sind, daβ die zwei Bereiche in Zonen der Abstufung angeordnet sind, welche gegenüber einer Referenzrichtung des Kartenkörpers unterschiedliche Richtungen aufweisen.

21. Karte nach Anspruch 19 oder Anspruch 20, **dadurch gekennzeichnet**, daβ jede Verbindungsklemme derart ausgebildet ist, daβ sie in wenigstens zwei Bereiche unterteilt ist, welche den Bereichen der anderen Verbindungsklemme entlang unterschiedlicher Richtungen gegenüberliegen.

22. Karte nach einem der Ansprüche 19 bis 21, **dadurch gekennzeichnet**, daβ jede Verbindungsklemme derart ausgebildet ist, daβ jede unter ihnen in wenigstens zwei Bereiche unterteilt ist, von welchen einer quer an den Hohlraum des Kartenkörpers angrenzt und der andere in Längsrichtung an diesen Hohlraum angrenzt.

23. Karte nach einem der Ansprüche 14 bis 22, **dadurch gekennzeichnet**, daβ die inneren Kontakte des Moduls, welche zu den Verbindungsklemmen schauen, aus einer Mehrzahl von Kontaktbereichen bzw. -stellen realisiert sind.

24. Karte nach Anspruch 23, **dadurch gekennzeichnet**, daβ die Kontaktbereiche derart angeordnet sind, um entlang unterschiedlicher Richtungen des Hohlraums anzugrenzen

25. Karte nach einem der Ansprüche 14 bis 24, **dadurch gekennzeichnet**, daβ der Kartenkörper aus Materialschichten realisiert ist, die aus der Gruppe, bestehend aus Polyvinylchlorid, Acrylnitril-butadienstyrol, Polyethylenterephthalat oder Polycarbonat gewählt sind.

26. Karte nach Anspruch 25, **dadurch gekennzeichnet**, daβ der Karfenkörper alternierend aus derartigen Schichten realisiert ist.
